# EUROPÄISCHE PATENTANMELDUNG

(11) **EP 2 521 428 A1**
(43) Veröffentlichungstag der Anmeldung: **07.11.2012**
(21) Anmeldenummer: 12003017.6
(22) Anmeldetag: 30.04.2012
(51) Int. Cl.: H05K 3/12, H05K 3/28

(54) **Verfahren und Vorrichtung zur digitalen Herstellung einer Ummantelung einer Funktionsschicht auf einer Substratoberfläche sowie Bauteil**

(30) Priorität: 05.05.2011 DE 102011100554
(71) Anmelder: Bauer, Jörg R., 88250 Weingarten (DE)
(72) Erfinder: Bauer, Jörg R., 88250 Weingarten (DE)

(57) **Zusammenfassung**

Verfahren zum Aufbringen von sich überlagernden Schichtbereichen auf eine Oberfläche mittels eines Aufbringverfahrens bei dem aushärtbare Flüssigkeitströpfchen digital gesteuert auf eine Oberfläche (10) aufgebracht werden, wobei die überlagernde geometrische Abmessung der Deckschicht (26) die Oberfläche und deren Kantenbereiche (20/a) der geometrischen Abmessung der Funktionsschicht (24) umschließt.

## Beschreibung

Die Erfindung betrifft ein Verfahren und eine Vorrichtung zum Aufbringen eines Schichtbereiches mit einer Ummantelung bildenden Eigenschaft mit vorbestimmten geometrischen Abmessungen auf einer Oberfläche sich befindenden Funktionsschicht, mittels eines Aufbringverfahrens bei dem Flüssigkeitströpfchen digital gesteuert aufgebracht werden und dort härten.

Bekannt ist, dass leitfähige Substanzen in flüssiger Form mittels elektronisch gesteuerter Druckköpfe in Tröpfchen auf eine Oberfläche abgegeben werden und dort härten. Leitende Flüssigkeiten sind darauf ausgelegt, nach deren gezieltem Auftrag und deren Trocknungsprozess eine optimale Leitfähigkeit zu ermöglichen. Die leitfähigen Flüssigkeiten haben wie bekannt in einer Ausführungsform z.B. feinste metallhaltige Partikel (Blättchen, Punktförmig) beigemengt. Wie bei Silbertinten bekannt, wird die Leitfähigkeit durch nachträgliche Wärmebehandlung noch erhöht. Diese leitfähigen Substanzen sind auf ihre optimale Leitfähigkeit und Kolloidalität in Abhängigkeit zum Druckkopf ausgelegt. Die physikalische Beanspruchbarkeit einer digital hergestellten Leiterbahn ist, bedingt durch ihre Zusammensetzung aus kleinsten Partikeln, nicht so hoch wie beispielsweise eine Leiterbahn die aus einem Metalldraht hergestellt ist.

**Die Problemstellung** ergibt sich daher, dass die mittels Digitaldruck aufgebrachten leitfähigen Strukturen, keine formangepasste Schutzschichten auf deren Oberfläche haben. Zerstörung und Beeinträchtigung der Leitfähigkeit/Funktionalität ist durch Reaktionen, Abrieb, Schwingungen (Wellen), chemische Reaktionen (Sauerstoff oder Wasser) gegeben. Selbst nahezu alle stromführenden konventionellen Kabel oder Kabelstränge, die in irgendeiner Form heute verbaut werden, sind durch einen formangepassten, isolierenden Kunststoffmantel geschützt.
Da es sich bei digital aufgebrachten Funktionsschichten zumeist um eine Vielzahl von geometrischen Formenanordnungen auf einer Oberfläche handelt (z.B.Leiterbahnen) wird hier bisher lediglich Abhilfe durch eine flächige Beschichtung mittels Sprühlack, Tauchbad oder herkömmlicher Druckverfahren in einer konstanten gleichbleibenden Schichtdicke geleistet.

Der Erfindung liegt die Aufgabe zu Grunde, eine Möglichkeit zu schaffen, mittels eines Aufbringverfahrens bei dem Flüssigkeitströpfchen digital präzise gesteuert abgegeben werden, eine Schutzummantelung auf vorbestimmter geometrischer Abmessung von leitfähigen Substanzen, kostengünstig und formangepaßt aufzubringen.

Eine Lösung dieses Problems wird mit dem Verfahren gemäß dem Anspruch 1 gelöst.

Die Unteransprüche 2 bis 14 sind auf vorteilhafte Durchführungsformen des erfindungsgemäßen Verfahrens gerichtet.

Eine weitere Lösung des Problems wird mit einer Vorrichtung gemäß dem Anspruch 15 gelöst.

Die Erfindung wird im Folgenden anhand schematischer Zeichnungen beispielsweise und mit weiteren Einzelheiten erläutert.

### Die Figuren stellen dar:

Figur 1 eine schematische Gesamtansicht einer erfindungsgemäßen Vorrichtung.
Figur 2 einen Querschnitt durch ein erfindungsgemäß mit einer Deckschicht und darunterliegende Funktionsschicht versehenen Substrates.
Figur3 einen Querschnitt durch eine andere Ausführungsform eines mit einer Funktionsschicht und einer darunterliegenden Trägerschicht und einer darüberangeordneten Deckschicht versehenen Substrates, wobei die Deckschicht sich mit der Trägerschicht verbindet.
Figur 4 einen Querschnitt durch eine andere Ausführungsform wobei mehrere Schichtebenen bestehend aus der Kombination von Deckschicht und Funktionsschicht überlagernd auf einer Oberfläche mit einer Trägerschicht aufgebracht werden.
Figur 5 einen Querschnitt durch ein erfindungsgemäß in einer Funktionsschicht zwischen einer Trägerschicht und einer darüberliegenden Deckschicht angeornet, ein Elektro- Elektronikmodul integriert ist.
Figur 6/a einen Querschnitt durch eine erfindungsgemäß versehene Substratoberfläche mit einer Funktionsschicht angeordnet auf einer Trägerschicht und einer darüberliegenden Deckschicht wobei die Deckschicht eine Kontaktstelle ausspart.

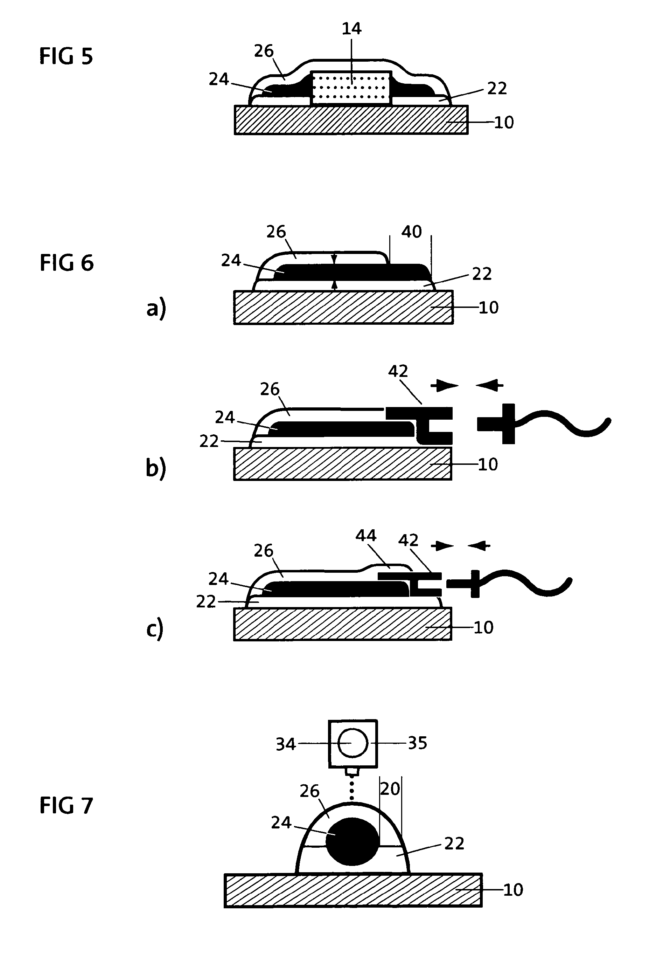

Figur 6/b einen Querschnitt durch eine andere Ausführungsform wobei auf der ausgesparten Kontaktstelle ein Kontaktvermittlungsbauteil angebracht ist.
Figur 6/c einen Querschnitt durch eine weitere Ausführungsform wobei auf der ausgesparten Kontaktstelle ein Kontaktvermittlungsbauteil angebracht ist und durch die überlagernde Deckschicht teilweise mit abgedeckt wird.
Figur 7 einen Querschnitt durch eine andere Ausführungsform wobei auf einer Substratoberfläche die Trägerschicht eine Negativformung der überlagernden Form der Funktionsschicht hat und eine Deckschicht sich mit der Trägerschicht verbindet.

Das Verfahren findet eine bevorzugte Anwendung im Digitaldruckprozess wobei Funktionsschichten beispielsweise Schaltungen, Schaltkreise oder Leiterbahnen auf Flächen (Vor- und Rückseite) oder Oberflächen von Körpern, wie Bauteilen oder Industriegütern digital aufzubringen sind.
So kann digital hergestellte Elektrik oder Elektronik (Funktionsschichten) mit einer belastbaren, dauerhaften Funktionalität eingeschlossen, zwischen einer möglichen darunterliegenden Trägerschicht und einer überlagernden Schutzschicht, auf folgenden Substratoberflächen aufgetragen werden wie:
Glas, Kunststoffe (wie PS, PE, PP, PET, Acryl, Harze), Metalle (wie Alu, Edelstahl, Legierungen), saugende Untergründe (wie Holz, Holzwerkstoffe, holzhaltige Werkstoffe), Papier, Karton (Papiere mit Füllstoffen, Farbanteilen und/oder Kunststoffen) oder Materialien die aus Materialkombinationen bestehen. Die Materialien können fest oder elastisch sein.

Die Substanzen, die die Trägerschicht und Schutzschicht bilden, können zu ihren isolierenden Eigenschaften gleichzeitig haftvermittelnde Eigenschaften (Primerfunktion) aufweisen. Die haftvermittelnde Eigenschaften bei der Trägerschicht zum Aufbringen auf oben aufgeführten Substratoberflächen ist spezifisch auf den Untergrund abzustimmen. Im Flüssigkeitsvorrat (32) ist es möglich die haftungsspezifische Trägerschicht (22) zu bevorraten und je nach Substratoberflächen (10) gesteuert den Druckköpfen (34) zuzuführen.
Digital abspritzbare Materialien für Deckschicht und Trägerschicht können vorzugsweise auf Basis von wasserbasierenden (z.B. Acryl), lösungsmittelbasierenden (z.B.Kunstharze), oder UV-härtenden Substanzen bestehen.

Desweiteren können die Flüssigkeiten, die für die Schichtbildungen, Deckschicht (26) und Trägerschicht (22) abgespritzt werden, mit inkjetfähigen Farbpigmenten eingefärbt sein. Mit diesen farbigen Flüssigeiten(26), (22) lassen sich auf einer Datenebene verschiedene elektr.-elektronischen Schichtbereiche wie Leiterbahnen mit spezifischen Farbummantelungen versehen. Im Datei-Layout der Haftschicht (16/a) und der Deckschicht (16/b) können die Farbzuordnungen der farbigen, geometrischen Flächen bestimmt und im Steuerprogramm hinterlegt werden.
Die verschieden farbigen Ummantelungen sind übergangslos bei gleichen Funktionseigenschaften aufbringbar.

Im Trocknungsprozess der Flüssigkeiten kann durch Licht- Wärmezuführung oder durch gleichzeitiges Abgeben einer Reaktionsflüssigkeit eine Aushärtung erfolgen.

Beim Zusammentreffen zwischen Trägerschicht und Deckschicht findet beim aufeinandertreffen der beiden Substanzen an den Kontaktstellen eine feste Materialverbindung statt. Deckschicht und Trägerschicht bilden eine geschlossene Kapselung um die Funktionsschicht.
Somit wird gewährleistet, dass bei:
- thermischen Schwankungen (unterschiedliche Ausdehnungen)
- Schwingungsfrequenzen (Wellen)
- physikalischer Beeinträchtigung (mechanische Beanspruchung, Elastizität)
- Zusammentreffen chemisch differenter Materialien
die durch die Schutzschichten gekapselte Funktionsschicht beim Aufbringen auf mögliche Substratoberflächen keine Haftungsprobleme oder Beeinträchtigung der Leitfähigkeit/Funktionalität auftreten.

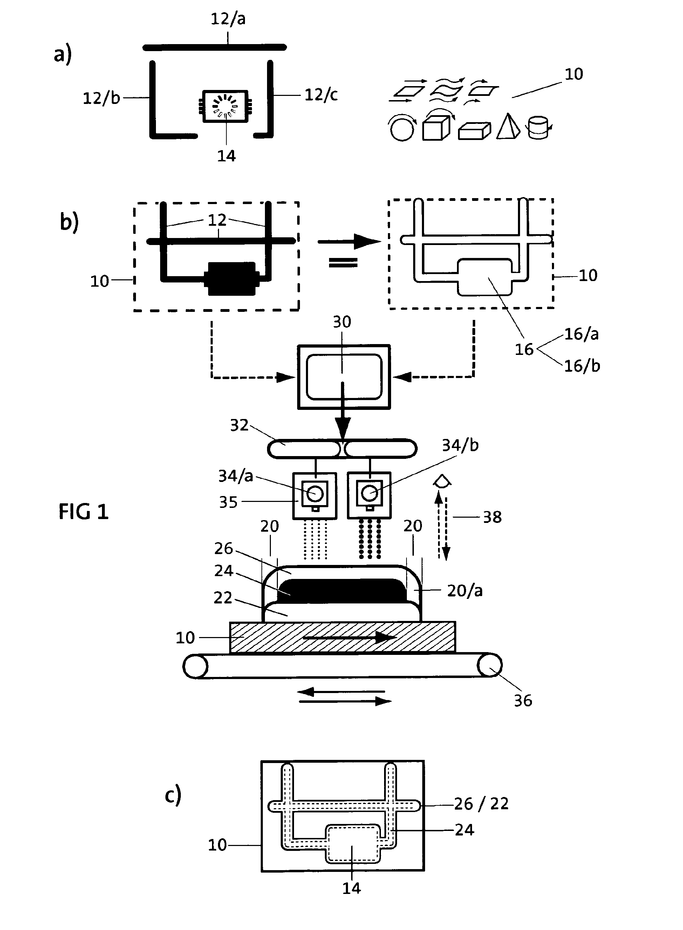

Figur 1 stellt schematisiert das Verfahren und die Vorrichtung dar.
Die Figur weist eine Vorrichtung zum Beschichten eines Subtrates mit aushärtenden Flüssigkeiten, eine Aufbringeinrichtung (35), eine Halterung (36) zum Halten oder Führen einer Fläche (10) oder eines Bauteils (10), eine Bewegungseinrichtung (36), mittels der die Oberfläche das Substrat (10) relativ zu der Aufbringeinrichtung (35) und der Bewegungseinrichtung sowie eine Härteeinrichtung und eine Messeinrichtung (38) auf.
Figur 1/b Die Aufbringeinrichtung (35) enthält einen oder mehrere Düsenköpfe (34) mit Flüssigkeitsdüsen, aus denen Flüssigkeitströpfchen mit vorbestimmtem Volumen und Vorschub abspritzbar sind. Der oder die Düsenköpfe (34) sind mit Flüssigkeitsvorratsbehältern (32) verbunden aus denen den Düsenköpfen bzw. deren Düsen unterschiedliche Flüssigkeiten (22), (24), (26) zugeführt werden können.
Die Halterung ist im dargestellten Beispiel durch ein Endlosband (36) gebildet das um Walzen umläuft, von denen wenigstens eine mittels eines Elektromotors drehantreibbar ist. Der oder die Düsenköpfe (34) sind mittels eines nicht dargestellten Antriebs in z-Richtung (vertikal und y-Richtung senkrecht zum Substrat bewegbar, so dass der oder die Düsenköpfe (34) relativ zu einer auf dem Endlosband (36) aufliegenden Fläche oder einem Körper beliebig bewegbar sind und aus dem oder den Düsenköpfen (34) Flüssigkeitströpfchen in genau vorbestimmter Weise auf vorbestimmte Stellen der Oberfläche des Subtrates (10) abspritzbar sind. Zur Positionsbestimmung des oder der Düsenköpfe (34) relativ zur Substratoberfläche kann in den oder die Düsenköpfe (34) eine nicht dargestellte Sensoreinrichtung integriert sein mit der einerseits die Position einer Düse relativ zur Substratoberfläche und anderseits die Position einer Düse relativ zur Substratoberfläche (10) in x-, y- und z-Richtung und beliebigen Neigungswinkeln bestimmt werden kann.

Zur Steuerung der Aufbringeinrichtung bzw. des Abspritzens der Flüssigkeitströpfchen und der Relativbewegung zwischen den Düsen und der Körperoberfläche (10) ist die in ihrem Aufbau an sich bekannte elektronische Steuerung (30) vorgesehen, die in unterschiedlichster Weise programmiert sein kann. Beispielsweise können in der elektronischen Steuereinrichtung (30) die Kontur der Körperoberfläche (10), deren Erstreckung in x-,y-,z Richtung, Eigenschaften der aufzubringenden Flüssigkeit(en), differenzierte Mengensteuerung der aufzubringenden Flüssigkeiten auf Positionen einer Flächeneinheit der Körperfläche, Relativbewegung zwischen dem Düsenkopf (34) und der Körperoberfläche (10), usw. abgelegt sein.

### Herstellung der Schichtebenen.

Figur 1/a zeigt den Datenlayoutaufbau einer Funktionsschicht, die aus einer oder wie dargestellt mehreren Leiterbahnen (12/a, 12/b, 12/c) und zusätzlichen Elektronikmodul(en) (14) bestehen kann. Im Layout wird die entsprechende Position auf dem Substrat (10) festgelegt. Die digital zu produzierenden Funktionen werden pro Ebene in einem Datensatz (In Figur 1/b) zusammengelegt zur Datei-Layout Funktionsschicht (12).
Figur 1/b zeigt, wie aus dem als Grundlage dienenden Datei-Layout der Funktionsschicht (12) das Datei-Layout der Trägerschicht und Deckschicht (16) hergestellt wird.
Das Datei-Layout (12) wird kopiert und als reine Flächendatei (Strichzeichnung) oder Konturdatei definiert. Beispielsweise im Format: TIFF, EPS, Halbton, Bitmap. Es können sämtliche sich auf einer Ebene befindlichen Funktionen oder Einzelbahnen in diesem neuen Datei-Layout (16) zusammengefaßt werden.
Die so definierte neue Datei bekommt eine Rand-Konturerweiterung (20) zugewiesen, z.B. 0,1 - 20 Punkt. Desweiteren ist es von Vorteil die Fläche dieser Randerweiterung (20) mit einer Deckraft (z.B. 90% - 100%) zu definieren.
Durch die Randerweiterung (20) ergibt sich, dass sich der Querschnitt der Linien und geometrischen Formen auf der Datei an allen Randbereichen in gleichem Verhältnis nach außen vergrößert. Entstanden ist jetzt ein Datensatz (16) der sowohl als Datei-Layout der Trägerschicht (16/a) und identisch auch als Datei-Layout der Deckschicht (16/b) verwendet wird.

Die Positionierung (Stand) der Datei-Layout Funktionsschicht (12) auf dem Substrat (10) wird identisch sowohl für das Datei-Layout der Trägerschicht (16/a) als auch für das Datei-Layout der Deckschicht (16/b) übernommen.

Zur Beschichtung des Substrates (10) wird in einem ersten Beschichtungsvorgang die Trägerschicht (22) mit haftvermittelnden Eigenschaften basierend auf den Daten der Träger-Layoutschicht (16/a) aufgetragen.
In einem folgenden Beschichtungsvorgang wird die Funktionsschicht (24) basierend auf den Daten der Datei-Layout Funktionsschicht (12) auf die Trägerschicht (22) aufgetragen.

In einem dritten, weiter überlagernden Beschichtungsvorgang wird die Deckschicht (26) basierend auf den Daten der Datei-Layout Deckschicht (16/b) randüberdeckend auf die Funktionsschicht (24) aufgetragen. Im Bereich der Randerweiterung (20) bildet die Deckschicht (26) mit der Trägerschicht (22) eine feste Verbindung.

Im Steuerprogramm ist hinterlegt, dass im Überlagerungsbereich der Deckschicht ein Mehrauftrag von formbildenden Deckschicht-Flüssigkeit aufgetragen wird.
Die Flüssigkeitströpfchen die über den Rand der Funktionsschicht (20) hinaus abgegeben werden sind so gesteuert, dass entsprechend der Kantenhöhe der Funktionsschicht ein entsprechendes Kanten-Randvolumen(20/a) hergestellt wird. Dies läßt sich gesteuert erreichen indem der Kantenerweiterung (20) eine größere Mengenabgabe an Flüssigkeitströpfchen zugewiesen wird.
Beim Auftrag der Schichten (22), (24), (26) kann jede Schicht mit einer konstanten Auftragshöhe gebildet werden. Darüber hinaus ist es möglich, variable Auftragsmengen auf einer geometrischen Abmessung einer Schichtebene aufzutragen. Dadurch ergeben sich steuerbare, variable Auftragsmengen bezogen auf eine Position bezogen auf einer Oberfläche.

Dies kann beispielsweise erfolgen, indem die erforderliche Volumenhöhe (20/a) der Kanten beschichtung durch größere Tröpfchen beim Abspritzen aus den Düsen geregelt abgegeben und erzeugt wird.
Eine weitere Möglichkeit einer gleichzeitigen Volumenerhöhung ist die geregelte Ansteuerung von mehreren Düsen.
Eine weitere Möglichkeit besteht in einen höheren differenzierten Schichtauftrag durch einen geringeren Vorschub.
Eine weitere Möglichkeit ist, durch die Verwendung einer Halbton- Datei zur Ansteuerung der Düsen im Datei-Layout (12), (16) der Schichten zu verwenden. Über die Datendichte kann die Abgabemenge definiert werden.
Berücksichtigt wird bei der Anwendung von mehrschichtigen, sich überlagernden gekapselter Funktionsschichten, dass evt. gewünschte Kontaktstellen entsprechend aus der Trägerschicht oder Deckschicht ausgespart werden.

Erweiternde Elektro-Elektronikmodule (24) können auf oder zwischen jeder Schichtebene mit aufgebracht werden und auf dem Substrat (10) integriert werden. Mit sämtlichen erweiternden Elektro-Elektronikmodulen (24) läßt sich mit den gleichen Möglichkeiten wie bei einer Funktionsschicht verfahren.

Durch die erfindungsgemäße Randzugabe ergibt sich jetzt, dass die aufgetragene Fläche der Trägerschicht (22) und die identische Fläche der Deckschicht (26) größer ist als die aufgetragene Fläche der Funktionsschicht (24).

Die Kanten-Randvolumenzugabe (20/a) und Schichtdicke von Trägerschicht (22) und Deckschicht (26) sind in ihren Abmessungen entsprechend ihrer Anforderung mit einer entsprechenden Schichtdicke/Auftragsmenge herstellbar.

Nicht immer ist es gewährleistet, dass zur Erzeugung von Funktionsschichten die abgegebenen Pixel aus den Druckköpfen präzise ihr Ziel ansteuern. So kann es vorkommen, dass sich im Randbereich einer solch hergestellten Leiterbahn einzelne Tröpfchen versetzen. Bedingt wird dies durch Verschleißerscheinungen der Druckköpfe oder unterschiedliche Flüssigkeitsdichten. Die versetzten Tröpfchen haben auf die Querschnittleitfähigkeit keine Funktionseinwirkung. Das Problem kann jedoch sein, dass so eine Brücke zu anderen Leitschichten bevorteilt wird. Durch die Randerweiterung (20) wird hier der Entstehung von Funktionsstörungen Abhilfe geschaffen.

Durch die Randerweiterung (20) werden auch beim Auftrag der Funktionschicht mechanische Ungenauigkeiten bei der Zuführung (36) des Substrates oder der relativen Bewegung der Druckköpfe (35) in Abhängigkeit zum Substrat kompensiert.

Figur 1/c zeigt die Darstellung eines Substrates (10) nach Fertigungsdurchlauf (Figur1/b), auf dessen Oberfläche mit einer geometrischen Abmessung aufgebrachten Leiterbahn (24) mit Zusatzmodul (14) die zwischenliegend, mit den vergrößerten geometrischen Abmessungen der Haftvermittlerschicht (22) und der Deckschicht (26) aufgebracht sind.

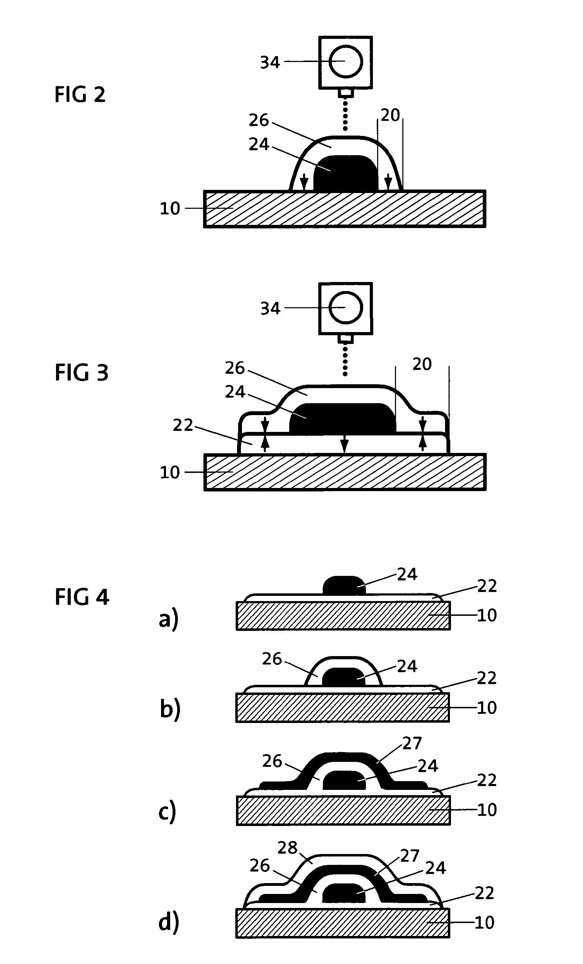

Figur 2 zeigt erfindungsgemäß eine Ausführungsform der Schnitt-Darstellung eines Substrates (10) mit einer direkt darauf aufgebrachten Leiterbahn (24) mit geometrischer Abmessung, die mit einer vergrößerten aufgetragenen Deckschicht (26) mit geometrischen Abmessungen (20) ummantelt ist.
Für die Anwendungsform, dass die zu beschichtende Substratoberfläche (10) keine leitenden Eigenschaften besitzt, beispielsweise eine Kunsstofffolie oder Papierart, kann die Ummantelung einer Funktionsschicht ohne eine Trägerschicht erfolgen. Die Kapselung (26) der Deckschicht erfolgt erfindungsgemäß über eine direkte Haftverbindung mit der Substratoberfläche (10).

Figur 3 zeigt die Schnittdarstellung bei der erfindungsgemäß auf die Oberfläche eines Substrates (10) einer darauf mit geometrischer Abmessung aufgebrachten Leiterbahn (24) die zwischenliegend einer mit geometrischen Abmessung aufgebrachten Trägerschicht (22) und einer mit geometrischen Abmessung aufgebrachten Deckschicht (26) ummantelt ist. Deckschicht (26) und Haftschicht (22) bilden an den sich überlagernden Flächen (20) eine geschlossene Haftverbindung. Die Zeichnung zeigt eine Ausführungsform mit einer vergrößerten Randerweiterung (20).

Figur 4 zeigt die Schnittdarstellung von sich überlagernden, erfindungsgemäßen Verfahrensanwendungen, wobei zwei unterschiedliche Funktionsschichten (24), (27) isolierend überlagernd voneinander auf einem Substrat(10) aufgebracht werden.

Figur 4/a zeigt die Substratschicht (10) worauf in einem ersten Schritt eine Trägerschicht (22) und darüber folgend, mit dazu korrespondierenden geometrischen Abmessungen überlagernder Funktionsschicht (24) aufgebracht ist (erste Funktionsebene).

In Figur 4/b bis 4/d bildet eine weitere Funktionsschicht (27) korrespondierend mit der geometrischen Abmessung der Deckschicht (28) eine zweite Funktionsebene.
Figur 4d zeigt, dass zwischen den Funktionsschichten (24) und (27) eine Trennschicht (26) aufgebracht ist.
Es besteht keine Verbindung zwischen den Funktionsschichten (28) und (24).

Nicht dargestellt ist, dass die Funktionsschichtebenen (24) und (27) an definierten, sich überlagernden Stellen untereinander eine Kontaktstelle bilden, indem in der dazwischenliegenden Trennschicht (26) eine definierte Stelle ausgespart wird.

Nicht gezeigt in den Darstellungen ist, dass auf diese Weise beliebig viele Funktionsebenen überlagernd angeordnet sein können. Sowohl mit den Merkmalen der gegenseitigen isolierenden Eigenschaften als auch von kontaktbildenden Stellen der Funktionsebenen untereinander.

Figur 5 zeigt wie auf einer Fläche oder Körper (10) funktionserweiternde elektrische- elektronische Bauteile (14) zu den digital aufgebrachten leitenden Strukturen (24) integriert werden können und mit einer Deckschicht gekapseltwerden.

Figur 6/a zeigt eine Ausführungsform wobei die Deckschicht (26) an einer Stelle ausgespart ist und eine Kontaktstelle (40) zur Funktionsschicht (24) in der Mantelung (26) entsteht.

In der Datei-Layout Deckschicht (16/b) ist durch Löschung der entsprechenden Dateifläche die Bildung einer Konstaktstelle hinterlegbar.

Figur 6/b zeigt die Substratschicht (10) worauf wie in Figur 5/b eine Kontaktstelle in der Mantelung zur Funktionsschicht hergestellt ist und auf dieser Kontaktstelle ein Kontaktvermittlungsbauteil (42) mit angebracht ist.
Das Kontaktvermittlungsbauteil (42) hat die Funktion, dass eine an-und absteckbare Schnittstelle geschaffen wird. Die Funktionen der Leiterbahnen sind durch entsprechende Zuordnung zu den Schnittstellen der Kabelsteckverbindungen vernetzbar. Durch die mechanische Beanspruchung (Abrieb) und der erforderlichen Stabilität einer solchen Steckverbindung (42) ist eine durch Tröpfchenbildung entstandene Funktionsschicht (26) nicht geeignet diese Merkmale zu erfüllen. Dies macht es notwendig ein zusätzliches Kontaktvermittlungsbauteil zu den Funktionsschichten (26) zu integrieren.

Figur 6/c zeigt eine erweiterte Ausführungsform bei der in Erweiterung zu Figur 6/b das Kontaktvermittlungsbauteil (42) in den Mantel der Deckschicht (26) eingeschlossen ist. Auf diese Weise lassen sich beispielsweise gekapselte, wasserfeste Platinen oder Elkro-Elektronikbauteil mit einem belastbaren Anschlußteil herstellen.

Figur 7 zeigt einen Querschnitt durch eine erfindungsgemäße Ausführungsform wobei auf einer Substratoberfläche (10) durch die mengengeregelte Abgabe der Flüssigkeitströpfchen (34) eine Formgebung (20) auf der geometrischen Abmessungen der Trägerschicht gebildet ist.
Die Formgebung der Trägerschicht (22) entspricht der Negativform der aufliegenden Form der Funktionsschicht (24), und bildet somit eine anliegende Aufnahmeformschicht.

Für die Funktionsschicht ergibt sich in dieser Ausführungsform, dass sich in einer runden oder kreisförmigen Kabel-Leiterbahn bei geringsten Querschnittabmessungen, die größtmögliche Kabelleistung bildet.

Die Kabel- Leiterbahnmantelung (24) wird erzeugt indem durch die mengengeregelte Abgabe der Flüssigkeitströpfchen auf der geometrischen Abmessungen der Deckschicht (26) eine geschlossene Formverbindung (20) zu der Trägerschicht (22) ergibt.

### Bezugszeichenliste

- 10: Substrat
- 12/a: Leiterbahn
- 12/b: Leiterbahn
- 12/c: Leiterbahn
- 12: Datei-Layout Funktionsschicht
- 14: Elektrik- Elektronikmodul
- 16/a: Datei-Layout Trägerschicht
- 16/b: Datei-Layout Deckschicht
- 20: Randkontur-Erweiterung
- 20/a: Kanten-Randvolumen
- 22: Trägerschicht
- 24: Funktionsschicht
- 26: Deckschicht
- 27: Funktionsschicht Ebene 2
- 28: Deckschicht Ebene 2
- 30: Steuereinrichtung
- 32: Flüssigkeitsvorrat
- 34: Druckkopf
- 36: Träger
- 38: Sensoreinrichtung
- 40: Kontaktstelle
- 42: Kontaktvermittlungsbauteil
- 44: Kontaktstelle Versiegelung

## Patentansprüche

1. Verfahren zum Aufbringen von sich überlagernden Schichtbereichen auf eine Oberfläche mittels eines Aufbringverfahrens bei dem aushärtbare Flüssigkeitströpfchen digital gesteuert auf eine Oberfläche (10) aufgebracht werden, wobei die überlagernde geometrische Abmessung der Deckschicht (26) die Oberfläche und deren Kantenbereiche (20/a) der geometrischen Abmessung der Funktionsschicht (24) umschließt.

2. Verfahren nach Anspruch 1, wobei die Fläche der geometrischen Abmessung der Deckschicht (26) gleich der Fläche der geometrischen Abmessung der Funktionsschicht (24) mit Zuweisung der Fläche einer Randkontur-Erweiterung (20) ist.

3. Verfahren nach einem der Ansprüche 1 bis 2, wobei als erster Schichtbereich eine Trägerschicht (22) mit den geometrischen Abmessungen der Deckschicht (16) zwischen Substrat (10) und den sich überlagernden Schichten der Deckschicht (26) und Funktionsschicht (24) wobei über den vergrößerten Randbereich (20) der geometrischen Abmes sung der Deckschicht (26) und dem vergrößerten Randbereich (20) der geometrischen Abmessung der Trägerschicht (22) eine geschlossene Haftverbindung entsteht (Funktionsschicht-Kapselung).

4. Verfahren nach einem der Ansprüche 1 bis 3, wobei beim Auftragen der Flüssigkeitströpfchen zur Herstellung einer geometrischen Abmessung einer Schichtebene (22), (24), (26) die Auftragsmengen positionsbezogen regelbar abzugeben sind.

5. Verfahren nach einem der Ansprüche 1 bis 4 wobei die Flüssigkeitströpfchen zur Bildung einer Deckschicht und/oder einer Trägerschicht eingefärbt oder transparent sind.

6. Verfahren nach einem der Ansprüche 1 bis 5 wobei der Auftrag von geometrischen Abmessungen von farbigen Schichtbereichen simultan erfolgen kann.

7. Verfahren nach einem der Ansprüche 1 bis 6, wobei die Deckschicht (26) und Trägerschicht (22), isolierende und/oder haftvermittelnde Eigenschaften besitzt.

8. Verfahren nach einem der Ansprüche 1 bis 7, wobei das Datei-Layout der geometrischen Abmessung der Funktionsschicht (12) aus dem Zusammensetzen einzelner geometrischen Abmessungen (12/a, 12/b, 12/c) gebildet wird.

9. Verfahren nach einem der Ansprüche 1 bis 8, wobei in der geometrischen Abmessung der Funktionsschicht ein Elektro-Elekronikmodul mit Bestandteil ist.

10. Verfahren nach einem der Ansprüche 1 bis 9, wobei mehrere Schichtebenen, bestehend aus der Kombination von Trägerschicht (22), Funktionsschicht (24) und Deckschicht (26) überlagernd auf einer Oberfläche (10) aufgebracht sind.

11. Verfahren nach einem der Ansprüche 1 bis 10, wobei beim Auftrag von mehreren überlagernden Schichtebenen die Deckschicht (26) zwischen zwei Funktionsschichten (24) an definierter Stelle eine Aussparung aufweist und eine Kontaktstelle zwischen den Funktionsschichten gebildet wird.

12. Verfahren nach einem der Ansprüche 1 bis 11, wobei die mantelbildende Schicht/en (22), (26) einer Funktionsschicht (24), durch eine Aussparung im Schichtauftrag, eine Kontakt stelle (40) zur Funktionsschicht (24) gebildet wird.

13. Verfahren nach einem der Ansprüche 1 bis 12, wobei in die Aussparung (40) der mantelbildenden Schicht/en (22), (26) mittels Anbringen eines Kontaktvermittlungs bauteil (42) eine vernetzbare Steck-Schnittstelle gebildet wird.

14. Verfahren nach einem der Ansprüche 1 bis 13, wobei das Kontaktvermittlungsbauteil (42) mit in die mantelbildende Deckschicht (26) so mit eingebunden wird, dass eine wasserfeste Kapselung gebildet wird.

15. Vorrichtung zum Aufbringen von sich überlagernden Schichtbereichen (22, 24, 26) auf eine Oberfläche (10) mittels eines Aufbringverfahrens bei dem aushärtbare Flüssigkeitströpfchen digital gesteuert auf eine Oberfläche aufgebracht werden, enthaltende Funktionseinheit zum Abspritzen von Flüssigkeiten, Flüssigkeitsvorratsbehälter (32), die jeweils mit wenigstens einer Aufbringeinheit verbunden sind und Flüssigkeiten enthalten,
ein Träger (36) zur Aufnahme eines Substrates (10), auf das die Schichten aufgebracht werden soll,
einer Bewegungseinrichtung (35) zum Erzeugen einer Relativbewegung zwischen der Aufbringeinrichtung und der zu beschichtenden Fläche oder Körper und
eine elektronische Steuereinrichtung (30) mit
einem Datenspeicher, in dem die geometrische Abmessung (12, 16/a, 16/b) und relative Position der Schichtbereiche sowie den Schichtbereichen zugeordnet, und die Zuordnung der aushärtbaren Flüssigkeiten (32) und deren Eigenschaften und Farbgebung eingegeben sind,
eine Recheneinheit, die die Daten der geometrischen Abmessung der Trägerschicht (22) und die geometrische Abmessung der Deckschicht (26) aus den Daten der geometrischen Abmessung mit Zugabe einer Randerweiterung (20), und die Regelung der positionsbezogenen Auftragsmenge (20/a) der überlagernden Schicht (14) berechnet, einer Steuereinrichtung zum Steuern der Bewegungsrichtung und des Abspritzens von Flüssigkeitströpfchen aus den Düsen derart,
dass die mit aushärtender Flüssigkeit bedeckende geometrischen Schichtbereiche der Funktionsschicht (24) nach dem Aushärten der Flüssigkeit und
in einem nachfolgenden darüber angeordneten mit aushärtender Flüssigkeit überdeckenden geometrischen Schichtbereichen der Deckschicht (26) nach dem Aushärten der Flüssigkeiten vollständig entsprechend ihren vorbestimmten geometrischen Ausrichtungen zur Oberfläche (10) oder mit dem geometrischen Schichtbereich (20) der Trägerschicht (22) eine Ummantelung bildet.

16. Bauteil mit einem Grundkörper (10), der entsprechend einem Verfahren nach einem der Ansprüche 1 bis 14 beschichtete Oberfläche aufweist.
